# EUROPÄISCHE PATENTSCHRIFT

(11) **EP 2 294 246 B1**
(45) Veröffentlichungstag und Bekanntmachung des Hinweises auf die Patenterteilung: **28.02.2018**
(21) Anmeldenummer: 09757388.5
(22) Anmeldetag: 14.05.2009
(51) Int. Cl.: C23C 16/46, B05D 7/24

(54) **VERFAHREN ZUM ABSCHEIDEN EINES DÜNNSCHICHTIGEN POLYMERS IN EINER NIEDERDRUCKGASPHASE**
METHOD FOR DEPOSITING A THIN-FILM POLYMER IN A LOW-PRESSURE GAS PHASE
PROCÉDÉ DE DÉPÔT D'UN POLYMÈRE À COUCHE MINCE EN PHASE GAZEUSE BASSE PRESSION

(30) Priorität: 03.06.2008 DE 102008026973; 14.04.2009 DE 102009003781
(43) Veröffentlichungstag der Anmeldung: 16.03.2011
(73) Patentinhaber: Aixtron SE, 52134 Herzogenrath (DE)
(72) Erfinder: GERSDORFF, Markus, 52134 Herzogenrath (DE)
(74) Vertreter: Grundmann, Dirk
(86) Internationale Anmeldenummer: PCT/EP2009/055795
(87) Internationale Veröffentlichungsnummer: WO 2009/147005

(56) Entgegenhaltungen:
- DE-A1- 10 136 858
- US-A- 5 804 259
- US-A- 6 133 148
- US-A1- 2008 241 380

## Beschreibung

Die Erfindung betrifft ein Verfahren zum Abscheiden ein oder mehrerer dünner Schichten, wobei ein insbesondere ein Polymer bildendes Prozessgas zusammen mit einem Trägergas mittels eines Gaseinlassorganes in eine Depositionskammer einströmt, um auf der Oberfläche eines auf einer dem Gaseinlassorgan beabstandet gegenüberliegenden Tragfläche eines Suszeptors aufliegenden Substrates eine dünne Schicht insbesondere in Form eines Polymers abzuscheiden.

Ein Verfahren der zuvor beschriebenen Art ist bekannt aus US 4,945,856. Dort wird festes Para-Xylylen in eine Gasform gebracht. Das Gas wird über Gasleitungen in eine Pyrolysekammer geleitet, wo das Dimer in ein Monomer zerlegt wird. Zusammen mit dem Trägergas wird das Monomer über eine weitere Gasleitung mit einem Gaseinlassorgan in eine Depositionskammer geleitet, wo es auf einem Substrat, welches auf einem gekühlten Suszeptor liegt, polymerisiert. Para-Xylylene-Copolymere werden von der US 3,288,728 beschrieben. Es handelt sich dabei um C-, N-, D-Polymere der Parylene-Familie, die bei Raumtemperatur im festen pulverförmigen oder flüssigem Zustand vorliegen.

Aus "Characterization of Parylene Deposition Process for the Passivation of Organic Light Emmiting Diodes", Korean J. Chem. Eng., 19(4), 722-727 (2002) ist es bekannt, OLEDs mit Schichten von Poly-P-Xylylene und dessen Derivate zu passivieren, insbesondere zu kapseln. Ansonsten ist es bekannt, verschiedenartige großflächige Substrate mit einer Parylene-Beschichtung im Vakuum zu versehen. So werden beispielsweise Glas, Metall, Papier, Lack, Kunststoff, Keramik, Ferrit und Silikon durch Kondensation aus der Gasphase mit einem porenfreien und transparenten Polymerfilm beschichtet. Dabei macht man sich die hydrophobe, chemisch resistente und elektrisch isolierende Eigenschaft der polymeren Beschichtung zunutze.

Die US 5,554,220 beschreibt einen sogenannten OVPD-Prozess, mit dem sogenannte OLEDs (Organic Light Emitting Devices) hergestellt werden können. Als Ausgangsstoff wird dort unter anderem DAST genannt.

Die DE 10136 858 beschreibt eine Vorrichtung und ein Verfahren zur Herstellung von beschichteten Substraten, wobei die Schicht mittels eines Kondensationsverfahrens auf einem Substrat aufgebracht wird. Als Substrat kommt Glas, eine Folie oder auch Kunststoffe in Betracht. Mit der dort beschriebenen Vorrichtung können lichtimitierende Bauelemente, insbesondere Dünnfilmbauelemente wie OLEDs hergestellt werden. Die organischen Schichten werden großflächig auf dem Substrat mit einer Maske strukturiert abgeschieden. Die Vorrichtung besitzt ein temperiertes Gaseinlassorgan in Form eines großflächigen Gasverteilers und einen darunter liegenden Suszeptor zur Aufnahme eines Substrates, welcher gekühlt ist.

Die EP 0 862 664 B1 befasst sich mit einem Verfahren und mit einer Vorrichtung zur Abscheidung von Parylen auf Halbleitersubstraten. In einer Verdampfungskammer wird Parylen verdampft. In einer Pyrolysekammer wird das verdampfte Parylen zerlegt. Die Zerlegungsprodukte gelangen durch ein Gaseinlassorgan in eine Prozesskammer und bilden auf einem auf unterhalb 15°C gekühlten Substrat eine Schicht. Der Substrathalter kann mittels einer Heizung bis 400°C aufgeheizt werden.

Die US 2006/0113507 A1 befasst sich ebenfalls mit einem Parylen-Abscheideverfahren unter Vakuumbedingungen. Dort soll in einem Einschrittverfahren ein Flüssigkristall-Polymerfilm abgeschieden werden. Der Prozess findet in einem Dreizonenreaktor statt, der eine Sublimationszone, eine Pyrolysezone und eine Kondensationszone mit einer Betriebstemperatur von 450°C bis 700°C besitzt. Die Sublimation soll bei einer Temperatur zwischen 15°C und 100°C stattfinden. Die Kondensation und die gleichzeitige Polymerisation soll bei einer Temperatur zwischen 210°C und 290°C stattfinden.

Die US 6,709,715 B1, US 6,362,115 B1 und US 5,958,510 beschreiben ein Verfahren zum Abscheiden von Parylen-Schichten unter Verwendung einer Vorrichtung, bei der ein polymerer Ausgangsstoff zunächst verdampft, dann zerlegt und die Zerlegungsprodukte über einen großflächigen Gasverteiler in eine Prozesskammer eingeleitet werden, welcher beheizt ist. Die Kondensation findet auf Substraten statt, die auf einem gekühlten Suszeptor liegen.

Die US 3,908,046 befasst sich mit einem Para-Xylylene-Polymerabscheideverfahren, was ebenfalls die Prozessschritte Sublimation, Pyrolyse und Deposition umfasst. Die Substrattemperatur wird hier in einem Bereich vom 25°C bis 30°C gehalten.

Das Beschichtungsverfahren zum Abscheiden der OLEDs oder der Polymere findet in einer Depositionskammer statt, bei dem ein vertikaler Temperaturgradient in der Gasphase vorhanden ist. Das Gaseinlassorgan hat eine höhere Temperatur als das Substrat. Letzteres muss deshalb durch Auflage auf dem Suszeptor gekühlt werden. Auf den Suszeptor muss die vom Gaseinlassorgan durch Strahlung auf das Substrat übertragende Wärme abgeleitet werden. Da der Beschichtungsprozess in der Regel bei Drucken im Sub-mbar-Bereich stattfindet, kann der Wärmeabfluss nur über Kontaktflächenabschnitte zwischen Substrat und Tragfläche des Suszeptors erfolgen. Es liegt in der Natur der beiden aufeinander liegenden Flächen von Tragfläche einerseits und Substratunterseite andererseits, dass ein echter, eine Wärmeleitung ermöglichender Kontakt nur sporadisch vorhanden ist. Wegen der nicht zu vermeidenden Unebenheiten der beiden Flächen bilden sich Spaltzwischenräume mit Spaltbreiten von bis zu 100 µm. Bei einem Prozessdruck von weniger als 1 mbar findet in diesem Spalt keine Wärmeübertragung durch Konvektion mehr statt. Dies hat zur Folge, dass sich die Oberfläche des zu beschichtenden Substrates durch die vom beheizten Gaseinlassorgan emittierte Strahlung auf Temperaturen aufheizt, die deutlich oberhalb der Suszeptortemperatur liegen. Der Erfindung liegt daher die Aufgabe zugrunde, ein Verfahren anzugeben, mit dem der Beschichtungsprozess bei Substrattemperaturen durchgeführt werden kann, die nur wenig höher liegen als die Temperatur der Tragfläche des Suszeptors.
Gelöst wird die Aufgabe durch die im Anspruch 1 angegebene Erfindung. Die Unteransprüche stellen vorteilhafte Weiterbildungen der Erfindung dar. Zunächst und im Wesentlichen ist vorgesehen, dass das Gaseinlassorgan und/oder die Tragfläche derart temperiert werden, dass die Temperatur der Tragfläche niedriger ist als die Temperatur des Gaseinlassorganes, wobei zeitlich vor dem Eintritt des Prozessgases in die Depositionskammer bei einem ersten Druck in der Depositionskammer, der bevorzugt im Millibarbereich liegt, das auf der Tragfläche aufliegende Substrat durch Wärmeabfluss zum Suszeptor auf eine Substrattemperatur stabilisiert wird, die nur wenig höher ist als die Temperatur der Tragfläche aber deutlich niedriger als die Temperatur des Gaseinlassorganes, nachfolgend der Druck in der Depositionskammer auf einen Prozessdruck, der bevorzugt im Submillibarbereich liegt, vermindert wird und bei Erreichen des Prozessdrucks das Prozessgas in die Depositionskammer eintritt. Das Verfahren eignet sich besonders zum Abscheiden ein oder mehrerer dünner Schichten aus polymerem Material, insbesondere Para-Xylylene, wobei ein fester oder flüssiger, insbesondere von einem Polymer, insbesondere Dimer gebildeter Ausgangsstoff in einem Verdampfer verdampft wird und der Ausgangsstoff, insbesondere das Dimer mittels eines Trägergases vom Verdampfer durch eine Trägergaszuleitung in eine Pyrolysekammer transportiert wird, in der Pyrolysekammer pyrolytisch, insbesondere in ein Monomer zerlegt wird, das Zerlegungsprodukt, insbesondere Monomer vom Trägergas aus der Pyrolysekammer in eine Depositionskammer transportiert wird, dort durch ein Gaseinlassorgan in die Depositionskammer einströmt und auf der Oberfläche eines auf einer Tragfläche eines Suszeptors aufliegenden Substrates als dünne Schicht polymerisiert, und wobei das Trägergas und ein nicht polymerisierter Teil des Zerlegungsproduktes, insbesondere Monomers aus einem Gasauslass aus der Prozesskammer austritt. Das Verfahren eignet sich ebenfalls besonders zum Abscheiden von OLEDs. Die in der Regel flüssigen oder festen Ausgangsstoffe werden bei diesem OVPD-Prozess in sogenannten Quellen bspw. durch Verdampfen in eine Gasform umgewandelt und dann unter Verwendung eines Trägergases durch Gasleitungen zur Depositionskammer transportiert. Dort befindet sich ein Gaseinlassorgan. Das Gaseinlassorgan und insbesondere die vom Gaseinlassorgan gebildete Gasaustrittsfläche sind bevorzugt vergoldet oder zumindest hochglanzpoliert. Die vergoldete, hochglanzpolierte Oberfläche der Gasaustrittsfläche besitzt somit eine Emissivität ε, die im Bereich von weniger als 0,04 liegt. Hierdurch ist die Strahlungsleistung des auf eine Temperatur die im Bereich zwischen 150°C und 250°C liegt, aufgeheizten Gaseinlassorganes minimiert. Trotzdem wird Wärme auf das Substrat übertragen, welche zum gekühlten Suszeptor abfließen muss. Letzterer wird im Bereich von -30°C bis 100°C temperiert. Der Temperaturunterschied zwischen Tragfläche und Gaseinlassorgan liegt somit bei mindestens 50°C, oft sogar bei mindestens 100°C. Die Erfindung betrifft im Wesentlichen eine Vorthermalisierung des Substrates, die vor dem eigentlichen Beschichtungsprozess durchgeführt wird. Während der Beschichtungsprozess im Sub-mbar-Bereich durchgeführt wird, also insbesondere bei Drucken zwischen 0,5 und 0,05 mbar und bevorzugt bei einem Totaldruck von etwa 0,1 mbar, erfolgt die dem Beschichtungsprozess vorangehende Thermalisierung bei einem Totaldruck in der Depositionskammer von > als 1 mbar, beispielsweise bei einem Totaldruck von etwa 5 mbar. Nachdem das Substrat in die Prozesskammer eingebracht worden ist, strömt zunächst ein Trägergas, bei dem es sich um ein Edelgas oder ein anderes, reaktionspassives und insbesondere inertes Gas handeln kann, durch das Gaseinlassorgan in die Prozesskammer ein. Durch einen Gasauslass tritt es aus der Prozesskammer wieder hinaus. Es wird von einer Vakuumpumpe abgesaugt. Mit einem der Vakuumpumpe vorgeordneten Ventil wird der Prozessdruck innerhalb der Depositionskammer geregelt. Zunächst wird ein Prozessdruck eingestellt, der größer ist als 1 mbar und bevorzugt etwa 5 mbar beträgt. Bei diesem Thermalisierdruck wird das Temperaturprofil in der Depositionskammer eingestellt. Dies bedeutet, dass das Gaseinlassorgan und insbesondere die zur Tragfläche hinweisende Gasaustrittsfläche auf einer Prozesstemperatur im Bereich von 150° C und 250° C gebracht wird. Die Temperatur des Suszeptors wird auf eine Suszeptortemperatur im Bereich von -30° C und 100°C eingestellt. Dies erfolgt bei einem Druck, bei dem die mittlere freie Weglänge der Gasmoleküle deutlich geringer ist, als die Spaltbreite des Spaltes zwischen der Unterseite des Substrates und der Tragfläche, so dass in dem Spalt eine konvektive Wärmeübertragung vom Substrat auf den Suszeptor stattfinden kann. In diesem ersten Prozessschritt wird die Substrattemperatur auf eine Temperatur stabilisiert, die nur wenige Grad höher ist als die Temperatur der Tragfläche. Die Temperaturdifferenz zwischen Substrattemperatur und Suszeptortemperatur ist geringer als 10°C. Die laterale Temperaturabweichungen auf der Substratoberfläche liegen im Bereich von maximal 1°C. Der Temperaturstabilisierungsprozess kann pyrometrisch oder anderweitig überwacht werden. Es ist ein Temperatursensor vorgesehen, mit dem bevorzugt über die Messung der vom Substrat ausgesandten Temperaturstrahlung dessen Oberflächentemperatur gemessen werden kann. Auch die anderen Temperaturen, also die Temperatur des Gaseinlassorganes und die Temperatur des Suszeptors werden mit geeigneten Messelementen, bei denen es hier sich auch um Thermoelemente handeln kann, gemessen. Ist ein stationärer Zustand erreicht, bei dem die Temperatur der Substratoberfläche einen Sollwert erreicht hat, wird mit Hilfe des der Vakuumpumpe vorgeordneten Regelventils der Depositionskammerdruck sehr schnell abgesenkt. In der Regel erreicht der Depositionskammerdruck innerhalb von zwei bis zehn Sekunden einen stabilisierten Prozessdruck, der etwa 0,1 mbar beträgt. Bei diesem Prozessdruck haben die Moleküle des Trägergases eine mittlere freie Weglänge, die zu groß ist, als das innerhalb des Spaltes zwischen Substrat und Tragfläche ein konvektiver Wärmetransport stattfinden könnte. Bis auf die vereinzelten Berührungspunkte, mit denen die Unterseite des Substrates auf dem Suszeptor aufliegt, ist das Substrat bei diesem Druck vom Suszeptor im Wesentlichen thermisch isoliert. Dies hat zur Folge, dass die vom Substrat absorbierte vom Gaseinlassorgan kommende Strahlungswärme nicht mehr in ausreichendem Maße abgeführt werden kann, so dass sich der Temperaturunterschied zwischen Substrat und Suszeptor stetig vergrößert. Die Wachstumsraten des Abscheidungsprozesses sind jedoch so groß, dass die Wachstumszeiten nur wenige Sekunden, beispielsweise 1 bis 4 Sekunden betragen können. Da die Wachstumszeiten also weniger als 10 Sekunden betragen, beträgt die zum Aufheizen des Substrates in Folge Wegfall der konvektiven Kühlung verbleibende Zeit weniger als 20 Sekunden. Die Wärmekapazität des Substrates ist ausreichend groß, so dass die in dieser Zeit erfolgende Steigerung der Substrattemperatur toleriert werden kann. Das Verfahren eignet sich im Besonderen für die Verwendung in einer Vorrichtung, bei der das Trägergas aus Gasaustrittsöffnungen einer Gasaustrittsfläche eines Gaseinlassorganes austritt, bei dem das Trägergas und das vom Trägergas transportierte Prozessgas in Form von "Gasstrahlen" in die Prozesskammer einströmt. Die Gasstrahlen strömen durch eine Vielzahl von Gasaustrittsöffnungen in die Prozesskammer und verbinden sich zu einem sich über die gesamte Tragfläche erstreckenden Volumengasstrom in Richtung auf die Tragfläche. Die Gasaustrittsfläche besitzt dabei eine Flächenerstreckung, die größer ist als die Flächenerstreckung der Tragfläche und insbesondere der Flächenerstreckung des Substrates. Entsprechend groß ist die strahlungsemittierende Fläche des Gaseinlassorganes. Die von der Gasaustrittsfläche emittierte Strahlung wird zufolge der Minimierung der Emissivität durch Vergolden und Hochglanzpolieren der Oberfläche aber minimiert. Als Prozessgas wird bevorzugt das zu einem Monomer zerlegte Para-Xylylene oder Substituiertes Para-Yxlylene verwendet. Dieses soll auf der Substratoberfläche als Polymer abgeschieden werden. Die Wachstumsraten liegen im Bereich von 100 nm/Sek. bis 200nm/Sek. Bei diesen Wachstumsraten können die erforderlichen Schichtdicken von 100 nm bis 1000 nm in wenigen Sekunden abgeschieden werden.

Ausführungsbeispiele der Erfindung werden anhand beigefügter Zeichnungen erläutert. Es zeigen:

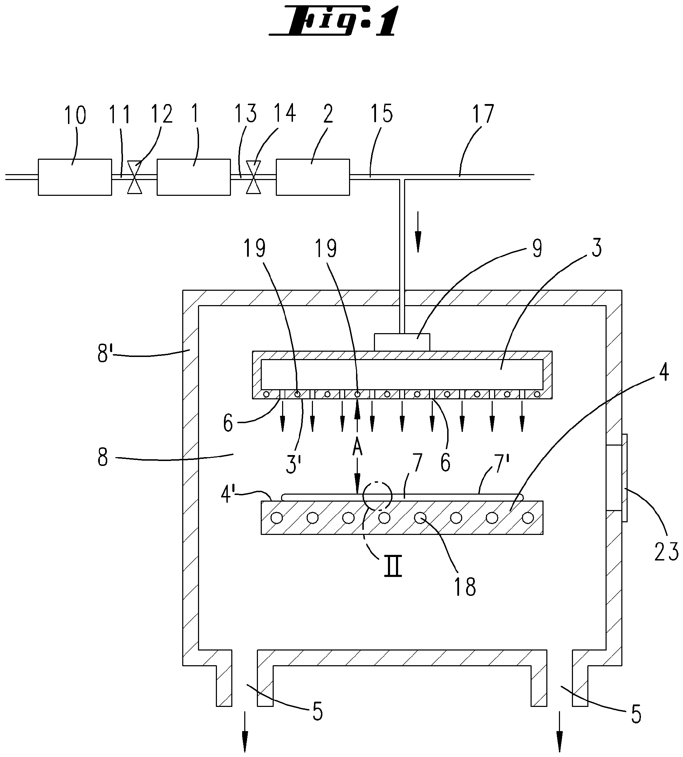

- Fig. 1: schematisch die wesentlichen Bestandteile der Beschichtungsvorrichtung und insbesondere den inneren Aufbau der Depositionskammer,
- Fig. 2: einen stark vergrößerten Ausschnitt II in Figur 1 zur schematischen Verdeutlichung des Spaltes zwischen Tragfläche 4' und Unterseite 7" des Substrates 7.

Eine nicht dargestellte Gasversorgung stellt ein Trägergas, beispielsweise Helium, Argon oder Stickstoff bereit, welches mit einem Massenflusskontroller 10 dosiert wird. Das Trägergas fließt durch eine Gasleitung 11, die mit einem Ventil verschließbar ist, in einen Verdampfer 1 ein, in welchem ein flüssiger oder fester Ausgangsstoff bevorratet ist. Bei diesem Ausgangsstoff handelt es sich um ein Polymer. Beispielsweise kann es sich um ein Polymer, beispielsweise Para-Xylylene oder substituiertes Para-Xylylene, beispielsweise C-, N-, D-Para-Xylylene handeln. Das Pulver bzw. die Flüssigkeit wird auf eine Quellentemperatur von 50°C bis 200°C beheizt. Bei dieser Temperatur verdampft der Ausgangsstoff in Form eines Dimers. Letzteres wird durch die Gasleitung 13, die von einem Ventil 14 verschließbar ist, zu einer Pyrolysekammer 2 geleitet. In der Pyrolysekammer 2 herrscht eine Temperatur zwischen 350°C und 700°C. Bei dieser Temperatur wird das Dimer in ein Monomer pyrolytisch zerlegt. Durch eine ebenfalls beheizte Zuleitung 15 wird das Trägergas zusammen mit dem Prozessgas über einen Eingangsverteiler 9 in ein Gaseinlassorgan 3 eingeleitet.

Die Strömungswiderstände in dem gesamten System sind so bemessen, dass innerhalb der Pyrolysekammer ein Gasdruck von weniger als 1 mbar herrscht. Die Strömungsgeschwindigkeit ist so eingestellt, dass die Ausgangsstoffe eine Verweilzeit in der Pyrolysekammer haben, die ausreicht, damit der Ausgangsstoff nahezu vollständig zerlegt wird.

Mit der Bezugsziffer 17 ist eine Zuleitung bezeichnet, durch die ebenfalls Gase in den Eingasverteiler 9 eingeleitet werden können. Durch die Leitung 17 kann aber lediglich nur das Trägergas in den Eingangsverteiler 9 eingeleitet werden. Ein nicht dargestelltes Vent-/Run-System kann vorgesehen sein, um Gasflüsse vor dem Eintritt in den Eingangsverteiler 9 zu stabilisieren.

Das Gaseinlassorgan 3 besitzt eine duschkopfartige Gestalt mit einer zentralen Kammer, in die das Gas mit dem Eingangsverteiler 9 gleichmäßig verteilt eingebracht wird. Der Boden der Kammer wird von einer Platte ausgebildet, welche Durchtrittsöffnungen 6 besitzt, die siebartig und gleichmäßig verteilt angeordnet sind. In der Platte, die mit ihrer Unterseite eine Gasaustrittsfläche 3' ausbildet, sind Heizdrähte oder Heizkanäle 19 angeordnet, durch die ein elektrischer Strom bzw. eine Heizflüssigkeit strömen kann. Mit der Widerstandsbeheizung oder der anderweitigen Beheizung kann das Gaseinlassorgan und insbesondere die Gasaustrittsfläche 3' auf Temperaturen im Beriech zwischen 150°C und 250°C aufgeheizt werden. Dabei ist der Durchmesser der insgesamt gleichgestalteten Gasaustrittsöffnungen 6 so gewählt, dass der Druckverlust über die Durchtrittsöffnungen weniger als 0,5 mbar beträgt.

In einem Abstand A unterhalb der Gasaustrittsfläche 3', welcher Abstand A viel kleiner ist als ein charakteristischer Durchmesser oder eine charakteristische Diagonale der Gasaustrittsfläche 3' ist, befindet sich ein Suszeptor 4. Die zur Gasaustrittsfläche 3' hinweisende, in einer Horizontalen liegende Auflagefläche 4' des Suszeptors 4 besitzt eine Flächenerstreckung, die geringer ist als die Flächenerstreckung der Gasaustrittsfläche 3'. Der Suszeptor 4 ist als Kühlblock gestaltet und besitzt Kanäle 18, durch die ein Kühlmedium strömt.

Die sich zwischen Gasaustrittsfläche 3' und Gasauflagefläche 4' erstreckende Depositionskammer 8 befindet sich in einem Reaktor, dessen Gehäusewand mit 8' bezeichnet ist. Letztere besitzt eine Beladungspforte 16 und Gasauslassöffnungen 5, durch welche das Trägergas und Reste des Prozessgases von einer Vakuumpumpe abgesaugt werden können.

Der Suszeptor 4 wird derartig gekühlt, dass seine Oberfläche 4' eine Suszeptortemperatur TS im Bereich von 0°C bis -50°C besitzt. Die Temperatur TG des Gaseinlassorganes 3 ist um mindestens 50°C, bevorzugt sogar mindestens 100°C höher als die Suszeptortemperatur TS. Um den Wärmetransport vom Gaseinlassorgan 3 zum Suszeptor 4 zu minimieren ist zumindest die Gasauslassfläche 3' hochglanzpoliert und insbesondere vergoldet, so dass ihre Emissivität kleiner als 0,04 ist.

Auf dem aus Edelstahl, Aluminium oder Kupfer bestehenden Suszeptor 4 liegt das Substrat 7. Es befindet sich in einem Abstand A von 25 mm bis 50 mm unterhalb der Gasaustrittsfläche 3'. Es kann sich dabei um ein dielektrisches aber auch um ein nicht dielektrisches Substrat handeln, beispielsweise um ein Display, einen Siliziumwafer oder auch um Papier oder um eine Kunststofffolie.

Handelt es sich bei dem Substrat um ein flächiges, flexibles Gebilde, so kann es zusätzlich auf einem Substratträger aufliegen. Des Weiteren sind nicht dargestellte Schattenmasken vorgesehen, um die Beschichtung lateral zu strukturieren. Das Substrat kann auch vorbeschichtet sein.

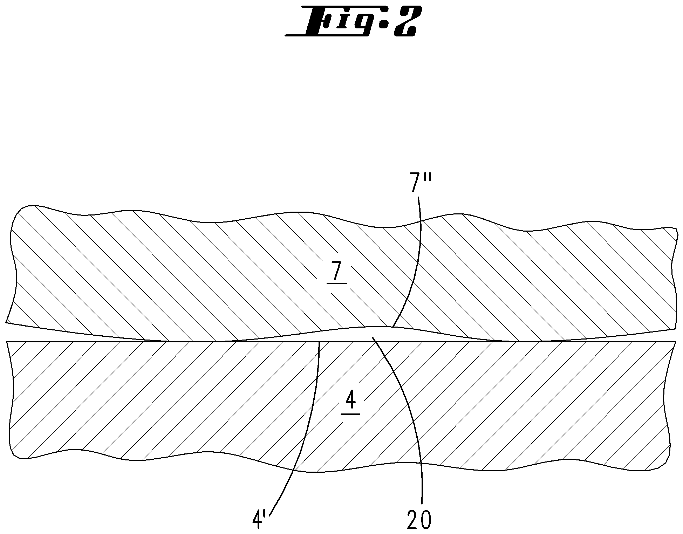

Die Figur 2 zeigt schematisch den Kontakt der Unterseite 7' des Substrates auf der Tragfläche 4' des Suszeptors 4. Obwohl beide Flächen im Wesentlichen eben verlaufen, sind Spaltzwischenräume 20 zwischen der Unterseite 7" und der Tragfläche 4' nicht zu vermeiden. Diese sind fertigungsbedingt oder treten durch thermische Verformung auf. Die Spaltweite dieser Spalte 20 liegt in der Größe zwischen 20µm und 100µm. Die Spalten nehmen eine größere Fläche in Anspruch, als die Berührungszonen der Unterseite 7" des Substrates 7 auf der Tragfläche 4'. Das Substrat hat somit nur eine vereinzelte Flächenanlage zum Suszeptor.

Bei einer typischen Prozessbedingung legt die Temperatur TG des Gaseinlassorganes 3 bei etwa 200°C und die Temperatur TS der Tragfläche 4' im Bereich zwischen 0°C und -50°C bevorzugt aber etwa bei 0°C. Die Temperatur TD der Oberfläche des Substrates 7 soll möglichst nur geringfügig höher sein als die Temperatur TS der Tragfläche 4'. Die Temperaturdifferenz sollte maximal im Bereich von 10°C liegen. Die auf 200°C temperierte Gasaustrittsfläche 3' erstreckt sich aber über die Fläche des Substrates 7 hinaus und überträgt somit via Wärmestrahlung erhebliche thermische Energie zum Substrat 7. Die Strahlungsleistung wird zwar durch die Hochganzpolitur der vergoldeten Oberfläche der Gasaustrittsfläche 3' minimiert. Sie führt aber trotzdem zu einem signifikanten Wärmezufluss zum Substrat. Dieser Wärmezufluss muss über eine möglichst großflächige Wärmeleitungsübertragungsstrecke an den Suszeptor 4 abgeführt werden. Der Temperaturunterschied zwischen Substrat 7 und Suszeptor 4 soll minimiert sein.

Wegen der geringen unmittelbaren Kontaktfläche zwischen Substrat 7 und Suszeptor 4 ist ein großer Wärmetransport über den Spalt 20 erforderlich. Bei einem Prozessdruck P2 von typischerweise 0,1 mbar herrschen praktisch isolierende Bedingungen, da die freie Weglänge der Gasmoleküle zu groß ist als dass ein konvektiver Wärmetransport zwischen den beiden voneinander beabstandeten Flächen 7" und 4' stattfinden könnte.

Erfindungsgemäß wird deshalb vor dem eigentlichen Beschichtungsprozess die gesamte Depositionseinrichtung 3, 4 inklusive des auf der Tragfläche 4' aufliegenden Substrates 7 bei erhöhtem Druck P1 in einem stationären Zustand gebracht, bei dem das das Einlassorgan 3 die Temperatur TG, der Suszeptor 4 und insbesondere die Trägfläche 4' die Temperatur TS und die Oberfläche des Substrates 7 die Substrattemperatur TD erreicht hat. Die Substrattemperatur TD liegt dabei nur wenig höher als die Temperatur TS. Die Temperaturdifferenz liegt bei weniger als 10°C. Diese Temperaturstabilisierung wird dadurch erreicht, dass der hierbei verwendete Thermalisierungsdruck größer ist als 1 mbar und etwa 5 mbar beträgt, also einen Wert hat, bei dem die mittlere freie Weglänge der Gasmoleküle ausreichend klein ist, um einen konvektiven Wärmetransport im Spalt 20 zwischen Substrat 7 und Tragfläche 4' zu gewährleisten.

Ist der stationäre Zustand erreicht, wird mit Hilfe eines Regelventils, welches vor der Vakuumpumpe angeordnet ist, die Saugleistung der Vakuumpumpe drastisch erhöht, so dass innerhalb von 2 bis 10 Sekunden der Totaldruck in der Depositionskammer 8 auf dem Prozessdruck P2 vermindert ist. Letzterer liegt im Sub-mbar-Bereich und beträgt etwa 0,1 mbar. Sobald dieser Prozessdruck P2 erreicht ist, folgt die eigentliche Beschichtung bei einer Wachstumsrate von etwa 100nm/Sek., bis die typische Schichtdicke von ca. 200 nm erreicht ist.

Es wird dabei in Kauf genommen, dass mit Beginn des Absenkens des Totaldrucks der konvektive Kühlmechanismus zwischen Substrat 7 und Suszeptor 4 aufgehoben wird und sich das Substrat 7 dann erwärmt. Der Temperaturanstieg ist wegen der nur wenige Sekunden dauernden Druckverminderungsphase und Wachstumsphase aber tolerierbar.

Mit dem zuvor beschriebenen Verfahren ist es möglich, großflächig Substrate zu beschichten. Die Tragfläche 4' kann beispielsweise eine Fläche von einem Quadratmeter aufweisen.

Ein weiteres Ausführungsbeispiel des erfindungsgemäßen Verfahrens betrifft das Abscheiden sogenannter OLEDs (Organic Light Emitting Devices). Auch hierbei handelt es sich um ein thermisches Vakuumverfahren. Die in der Regel flüssigen oder festen Ausgangsstoffe werden in temperierten Behältern, den sogenannten Quellen bevorratet. Durch Verdampfen werden die Ausgangsstoffe in eine Gasform umgewandelt, die dann mittels eines Trägergases durch eine Gasleitung 15, 17 in die Depositionskammer 8 transportiert werden. Dort befindet sich das Gaseinlassorgan 3 zum Verteilen und zur Dosierung des im Trägergas transportierten Prozessgases. Es tritt durch die Durchtrittsöffnungen 6 in die Prozesskammer 8 und kondensiert dort auf dem gekühlten Substrat 7. Letzteres liegt auf einem gekühlten Suszeptor 4 auf. Das Abscheiden der Schicht erfolgt bei Temperaturen deutlich unter 200°C. Dies ist erforderlich, da die verwendeten Ausgangsstoffe sehr temperaturinstabil sind. Während die Substrattemperatur TS somit einen niedrigen Wert besitzt, besitzt die Gaseinlasstemperatur TG einen deutlich höheren Wert, bspw. die Temperatur, bei der der Ausgangsstoff verdampft. Um zu vermeiden, dass sich die Substratoberfläche durch Wärmestrahlung vom Gaseinlassorgan 3 auf zu hohe Werte aufheizt, wird die Prozesskammer vor dem eigentlichen Depositionsprozess auf einem Druck P1 gehalten, der deutlich über dem Druck P2 ist, bei dem der Prozessschritt durchgeführt wird. Beim Druck P1 findet in den Freiräumen zwischen Substratunterseite und Substrathalteroberseite ein Wärmeaustausch zwischen Substrat und Substrathalter über Wärmeleitung statt. Der Prozess wird bei einem Prozessdruck P2 durchgeführt, der deutlich geringer ist. Bei diesem Prozessdruck P2 findet ein deutlich reduzierter Wärmetransport über Wärmeleitung in dem Spalt zwischen Substratunterseite und Suszeptoroberseite statt.

## Patentansprüche

1. Verfahren zum Abscheiden ein oder mehrerer dünner Schichten, wobei ein insbesondere organisches Material oder ein Polymer bildendes Prozessgas zusammen mit einem Trägergas mittels eines Gaseinlassorganes (3) in eine Depositionskammer (8) einströmt, um auf der Oberfläche (7') eines auf einer dem Gaseinlassorgan (3) beabstandet gegenüberliegenden Tragfläche (4') eines Suszeptors (4) aufliegenden Substrates (7) eine dünne Schicht insbesondere in Form eines Polymers abzuscheiden, **dadurch gekennzeichnet, dass** das Gaseinlassorgan (3) und/oder die Tragfläche (4') derart temperiert werden, dass die Temperatur (TS) der Tragfläche (4') niedriger ist als die Temperatur (TG) des Gaseinlassorganes (3), wobei zeitlich vor dem Eintritt des Prozessgases in die Depositionskammer (8) bei einem ersten Druck (P1) in der Depositionskammer (8) das auf der Tragfläche (4') aufliegende Substrat (7) durch Wärmeabfluss zum Suszeptor (4) auf eine Substrattemperatur (TD) stabilisiert wird, die nur wenig höher ist als die Temperatur (TS) der Tragfläche (4') aber deutlich niedriger als die Temperatur (TG) des Gaseinlassorganes (3), nachfolgend der Druck (P1) in der Depositionskammer (8) auf einen Prozessdruck (P2) vermindert wird und bei Erreichen des Prozessdrucks (P2) das Prozessgas in die Depositionskammer (8) eintritt.

2. Verfahren nach Anspruch 1, **dadurch gekennzeichnet, dass** das Trägergas bzw. das Prozessgas aus Öffnungen (6) der hochglänzenden und insbesondere vergoldeten Gasaustrittsfläche (3') austritt.

3. Verfahren nach einem der vorhergehenden Ansprüche, **dadurch gekennzeichnet, dass** ein die Gasaustrittsfläche (3') ausbildendes, duschkopfartig ausgebildetes Gaseinlassorgan (3) beheizt ist.

4. Verfahren nach einem der vorhergehenden Ansprüche, **dadurch gekennzeichnet, dass** das Gaseinlassorgan (3) mittels elektrischen Heizdrähten oder flüssigkeitsdurchströmten Kanälen (19) beheizt wird.

5. Verfahren nach Anspruch 4, **dadurch gekennzeichnet, dass** die Heizdrähte oder die flüssigkeitsdurchströmten Kanäle (19) in eine die Gasaustrittsfläche (3') ausbildenden Frontplatte des Gaseinlassorganes (3) angeordnet sind.

6. Verfahren nach einem der vorhergehenden Ansprüche, **dadurch gekennzeichnet, dass** der von einem Kühlblock gebildete Suszeptor (4) aktiv gekühlt wird.

7. Verfahren nach einem der vorhergehenden Ansprüche, **dadurch gekennzeichnet, dass** die Temperatur (TG) der Gasaustrittsfläche (3') um mindestens 50°C bevorzugt mindestens 100°C höher ist als die Temperatur (TS) der Tragfläche (4') und insbesondere im Bereich zwischen 150°C und 250°C liegt und bevorzugt etwa 200°C beträgt.

8. Verfahren nach einem der vorhergehenden Ansprüche, **dadurch gekennzeichnet, dass** die Temperatur des Suszeptors im Bereich von -30°C und 100°C liegt und bevorzugt im Bereich unter 0°C liegt.

9. Verfahren nach einem der vorhergehenden Ansprüche, **dadurch gekennzeichnet, dass** der Prozessdruck (P2) geringer ist als 1 mbar und bevorzugt im Bereich zwischen 0,5 mbar und 0,05 mbar liegt und besonders bevorzugt 0,1 mbar beträgt.

10. Verfahren nach einem der vorhergehenden Ansprüche, **dadurch gekennzeichnet, dass** die Temperaturstabilisierung bei einer Substrattemperatur (TD) von weniger als 100°C bevorzugt weniger als 10°C bei einem Thermalisierungsdruck (P1) von mehr als 1 mbar bevorzugt etwa 5 mbar erfolgt.

11. Verfahren nach einem der vorhergehenden Ansprüche, **dadurch gekennzeichnet, dass** das Prozessgas von einem verdampften Monomer eines polymeren Ausgangsstoffs, insbesondere Para-Xylylene oder substituierten Para-Xylylene ist.

12. Verfahren nach einem der vorhergehenden Ansprüche, **dadurch gekennzeichnet, dass** das Prozessgas verdampfte flüssige oder feste Ausgangsstoffe sind, die als lichtimitierende oder photovoltische Schichten insbesondere in Form von OLEDs auf dem Substrat (7) kondensieren.

13. Verfahren nach einem der vorhergehenden Ansprüche, **dadurch gekennzeichnet, dass** zum Abscheiden ein oder mehrerer dünner Schichten aus polymerem Material, insbesondere Para-Xylylene, ein fester oder flüssiger insbesondere von einem Polymer, insbesondere Dimer gebildeter Ausgangsstoff in einem Verdampfer (1) verdampft wird, der Ausgangsstoff, insbesondere das Dimer mittels eines Trägergases vom Verdampfer (1) durch eine Trägergaszuleitung (13) in eine Pyrolysekammer (2) transportiert wird, in der Pyrolysekammer (2) pyrolytisch, insbesondere in ein Monomer zerlegt wird, das Zerlegungsprodukt, insbesondere Monomer vom Trägergas aus der Pyrolysekammer (2) in die Depositionskammer (8) transportiert wird, dort durch das Gaseinlassorgan (3) in die Depositionskammer (8) einströmt und auf der Oberfläche (7') des auf einer Tragfläche (4') eines Suszeptors (4) aufliegenden Substrates (7) als dünne Schicht polymerisiert, und wobei das Trägergas und ein nicht polymerisierter Teil des Zerlegungsproduktes, insbesondere Monomers aus einem Gasauslass (5) aus der Prozesskammer (8) austritt.

14. Verfahren nach Anspruch 13, **dadurch gekennzeichnet, dass** das Zerlegungsprodukt, insbesondere Monomer zusammen mit dem Trägergas aus Gasaustrittsöffnungen (6) einer Gasaustrittsfläche (3) eines vom Gaseinlass (3) ausgebildeten Gasflächenverteilers in Richtung senkrecht auf die Substratoberfläche (7') in Form dicht benachbarter, sich zu einem im Wesentlichen sich über die gesamte Tragfläche erstreckenden Volumengasstrom verbindenden "Gasstrahlen" in die Prozesskammer (8) einströmt, wobei die Gasaustrittsöffnungen (6) über die gesamte, parallel zur Tragfläche (4') sich erstreckende Gasaustrittsfläche (3') verteilt sind.

15. Verfahren nach einem der vorhergehenden Ansprüche, **dadurch gekennzeichnet, dass** die Flächenerstreckung der Gasaustrittsfläche (3) größer ist als die Flächenerstreckung der Tragfläche (4') bzw. des Substrates.

## Claims

1. Method for depositing one or more thin layers, an in particular organic material or a process gas forming a polymer flowing, together with a carrier gas, into a deposition chamber (8) by means of a gas inlet element (3), in order to deposit a thin layer, in particular in the form of a polymer, on the surface (7') of a substrate (7) supported on a supporting surface (4') of a susceptor (4), the supporting surface being located opposite the gas inlet element (3) and at a spacing from it, **characterized in that** the temperatures of the gas inlet element (3) and/or the supporting surface (4') are controlled in such a way that the temperature (TS) of the supporting surface (4') is lower than the temperature (TG) of the gas inlet element (3), the substrate (7) supported on the supporting surface (4') being stabilised at a substrate temperature (TD) by flow of heat to the susceptor (4) at a time before the process gas enters the deposition chamber (8) when the pressure in the deposition chamber (8) is at a first pressure (P1), the substrate temperature (TD) being only slightly higher than the temperature (TS) of the supporting surface (4') but considerably lower than the temperature (TG) of the gas inlet element (3), the pressure (P1) in the deposition chamber (8) being subsequently reduced to a process pressure (P2) and the process gas entering the deposition chamber (8) when the process pressure (P2) has been reached.

2. Method according to Claim 1, **characterized in that** carrier gas and the process gas exit from ports (6) of the gas discharge surface (3'), which surface has a high-gloss finish and is in particular gold-plated.

3. Method according to any of the preceding claims, **characterized in that** a gas inlet element (3) that forms the gas discharge surface (3') and is formed in the manner of a shower head, is heated.

4. Method according to any of the preceding claims, **characterized in that** the gas inlet element (3) is heated by means of electric heating wires or by channels (19) through which liquid flows.

5. Method according to Claim 4, **characterized in that** the heating wires or the channels (19) through which liquid flows are located in a front plate of the gas inlet element (3), the front plate forming the gas discharge surface (3').

6. Method according to any of the preceding claims, **characterized in that** the susceptor (4), which is formed by a cooling block, is actively cooled.

7. Method according to any of the preceding claims, **characterized in that** the temperature (TG) of the gas discharge surface (3') is higher than the temperature (TS) of the supporting surface (4') by at least 50°C, preferably is at least 100°C higher, and in particular, is in the range between 150°C and 250°C, and is preferably approximately 200°C.

8. Method according to any of the preceding claims, **characterized in that** the temperature of the susceptor is in the range between -30°C and 100°C, and is preferably in the region below 0°C.

9. Method according to any of the preceding claims, **characterized in that** the process pressure (P2) is less than 1 mbar and is preferably in the range between 0.5 mbar and 0.05 mbar, and is especially preferably 0.1 mbar.

10. Method according to any of the preceding claims, **characterized in that** the temperature stabilization takes place with a substrate temperature (TD) less than 100°C, preferably less than 10°C, and with the thermalization pressure (P1) more than 1 mbar, preferably approximately 5 mbar.

11. Method according to any of the preceding claims, **characterized in that** the process gas is of an evaporated monomer or a polymeric starting material, in particular para-xylylene or substituted para-xylylene.

12. Method according to any of the preceding claims, **characterized in that** the process gas is evaporated liquid or solid starting materials, which condense on a substrate (7) as light limiting or photovoltaic layers, in particular in the form of OLEDs.

13. Method according to any of the preceding claims, **characterized in that**, for depositing one or more thin layers of polymeric material, in particular para-xylylene, a solid or liquid starting material formed in particular from a polymer, especially a dimer, is evaporated in an evaporator (1), and the starting material, in particular the dimer, is transported by means of a carrier gas from the evaporator (1) through a carrier gas line (13) into a pyrolysis chamber (2), is decomposed pyrolytically in the pyrolysis chamber (2), in particular into a monomer, f the decomposition product, in particular monomer, is transported out of the pyrolysis chamber (2) into the deposition chamber (8) by the carrier gas, there flows into the deposition chamber (8) through the gas inlet element (3) and is polymerized as a thin layer on the surface (7') of the substrate (7) supported on the supporting surface (4') of a susceptor (4), and the carrier gas and a non-polymerized portion of the decomposition product, in particular monomer, exiting from the process chamber (8) out of a gas outlet (5).

14. Method according to Claim 13, **characterized in that** the decomposition product, in particular monomer, flows into the process chamber (8), together with the carrier gas, from gas discharge ports (6) of a gas discharge surface (3') of a gas surface distributor formed by the gas inlet (3), in a direction perpendicular to the substrate surface (7') and in the form of "gas jets' that are closely adjacent and combine into a gas volume flow extending substantially over the entire supporting surface, the gas discharge ports (6) being distributed over the entire gas discharge surface (3') that extends parallel to the supporting surface (4').

15. Method according to any of the preceding claims, **characterized in that** the extent of the area of the gas discharge surface (3) is greater than the extent of the area of the supporting surface (4') or that of the substrate.

## Revendications

1. Procédé de dépôt d'une ou de plusieurs couches minces, dans lequel un matériau, notamment organique, ou un gaz de traitement formant un polymère est introduit conjointement avec un gaz porteur, au moyen d'un élément d'entrée de gaz (3), dans une chambre de dépôt (8) pour déposer sur la surface {7') d'un substrat (7), placé sur une surface porteuse (4') d'un suscepteur (4), laquelle surface porteuse fait face à l'élément d'admission de gaz (3) en étant espacée de celui-ci, une mince couche se présentant notamment sous la forme d'un polymère, **caractérisé en ce que** l'élément d'entrée de gaz (3) et/ou la surface porteuse (4') sont équilibrés en température de sorte que la température (TS) de la surface porteuse (4') soit inférieure à la température (TG) de l'élément d'entrée de gaz (3) ; temporellement avant l'entrée du gaz de traitement dans la chambre de dépôt (8) à un première pression (P1) dans la chambre de dépôt (8), le substrat (7) placé sur la surface porteuse (4') est stabilisé, par dégagement de chaleur vers le suscepteur (4), à une température de substrat (TD) qui n'est que légèrement supérieure à la température (TS) de la surface porteuse (4') mais nettement inférieure à la température (TG) de l'élément d'entrée de gaz (3), puis la pression (P1) dans la chambre de dépôt (8) est réduite à une pression de traitement (P2) et, lorsque la pression de traitement (P2) est atteinte, le gaz de traitement entre dans la chambre de dépôt (8).

2. Procédé selon la revendication 1, **caractérisé en ce que** le gaz porteur ou le gaz de traitement sort par des ouvertures (6) de la surface de sortie de gaz (3') très brillant et en particulier doré (3').

3. Procédé selon l'une des revendications précédentes, **caractérisé en ce qu'**un élément d'entrée de gaz (3) de type pomme de douche, qui forme la surface de sortie de gaz (3'), est chauffé.

4. Procédé selon l'une des revendications précédentes, **caractérisé en ce que** l'élément d'entrée de gaz (3) est chauffé au moyen de fils chauffants électriques ou de conduits (19) traversés par un liquide.

5. Procédé selon la revendication 4, **caractérisé en ce que** les fils chauffants ou les conduits (19) traversés par un liquide sont disposés dans une plaque avant de l'élément d'entrée de gaz (3), laquelle forme la surface de sortie de gaz (3').

6. Procédé selon l'une des revendications précédentes, **caractérisé en ce que** le suscepteur (4), formé par un bloc de refroidissement, est activement refroidi.

7. Procédé selon l'une des revendications précédentes, **caractérisé en ce que** la température (TG) de la surface de sortie de gaz (3') est supérieure d'au moins 50 °C, de préférence d'au moins 100 °C, à la température (TS) de la surface porteuse (4') et en particulier dans la gamme comprise entre 150 °C et 250 °C et de préférence égale à environ 200 °C.

8. Procédé selon l'une des revendications précédentes, **caractérisé en ce que** la température du suscepteur est dans la gamme allant de -30 °C à 100 °C et de préférence dans la gamme inférieure à 0 °C.

9. Procédé selon l'une des revendications précédentes, **caractérisé en ce que** la pression de traitement (P2) est inférieure à 1 mbar et de préférence dans la gamme comprise entre 0,5 mbar et 0,05 mbar et de manière particulièrement préférée égale à 0,1 mbar.

10. Procédé selon l'une des revendications précédentes, **caractérisé en ce que** la stabilisation de la température est effectuée à une température de substrat (TD) de moins de 100 °C, de préférence de moins de 10 °C, à une pression de thermalisation (P1) de plus de 1 mbar, de préférence d'environ 5 mbar.

11. Procédé selon l'une des revendications précédentes, **caractérisé en ce que** le gaz de traitement est formé d'un monomère vaporisé d'un matériau de départ polymère, en particulier de para-xylylène ou de para-xylylène substitué.

12. Procédé selon l'une des revendications précédentes, **caractérisé en ce que** le gaz de traitement est formé par des matières de départ solides ou liquides vaporisées qui sont condensées sur le substrat (7) en couches photoémettrices ou photovoltaïques, en particulier sous forme d'OLED.

13. Procédé selon l'une des revendications précédentes, **caractérisé en ce que**, pour déposer une ou plusieurs couches minces de matière polymère, en particulier de para-xylylène, une matière de départ solide ou liquide, formée par un polymère, en particulier un dimère, est vaporisée dans un évaporateur (1), la matière de départ, en particulier le dimère, est transportée au moyen d'un gaz porteur de l'évaporateur (1) jusque dans une chambre de pyrolyse (2) par un conduit d'alimentation en gaz porteur (13) et est décomposée dans la chambre de pyrolyse (2) par voie pyrolytique, en particulier en un monomère, le produit de décomposition, en particulier le monomère, est transporté par le gaz porteur de la chambre de pyrolyse (2) jusque dans la chambre de dépôt (8) où il pénètre par le biais de l'élément d'entrée de gaz (3) dans la chambre de dépôt (8) et polymérise sur la surface (7') du substrat 7), placé sur une surface porteuse (4') d'un suscepteur (4), sous la forme d'une couche mince, le gaz porteur et une partie non polymérisée du produit de décomposition, en particulier du monomère, sortant de la chambre de traitement (8) par une sortie de gaz (5).

14. Procédé selon la revendication 13, **caractérisé en ce que** le produit de décomposition, en particulier le monomère, s'écoule jusque dans la chambre de traitement conjointement avec le gaz porteur par des ouvertures de sortie de gaz (6) d'une surface de sortie de gaz (3) d'un répartiteur de surface de gaz, formé par l'entrée de gaz (3), perpendiculairement à la surface de substrat (7) sous la forme de « jets de gaz » étroitement adjacents qui s'unissent pour former un flux de gaz volumique s'étendant sensiblement sur toute la surface porteuse, les ouvertures de sortie de gaz (6) étant réparties sur toute la surface de sortie de gaz (3') s'étendant parallèlement à la surface porteuse (4').

15. Procédé selon l'une des revendications précédentes, **caractérisé en ce que** l'étendue de la surface de sortie de gaz (3) est supérieure à l'étendue de la surface porteuse (4') ou du substrat.
